(19) **Europäisches Patentamt**

**European Patent Office**

**Office européen des brevets**

(11) **EP 1 133 063 B1**

(12) **EUROPÄISCHE PATENTSCHRIFT**

(45) Veröffentlichungstag und Bekanntmachung des Hinweises auf die Patenterteilung:
**20.08.2003 Patentblatt 2003/34**

(51) Int Cl.7: **H03M 13/41**

(21) Anmeldenummer: **01108652.7**

(22) Anmeldetag: **04.06.1998**

(54) **Verfahren und Einrichtung zu quellengesteuerten Kanaldecodierung mit Hilfe eines Kalman-Filters**

Method and device for source-controlled channel decoding wih a Kalman filter

Méthode et appareil pour décodage canal contrôlé par source à l'aide d'un filtre de Kalman

(84) Benannte Vertragsstaaten:
**DE ES FR GB IT**

(30) Priorität: **23.06.1997 DE 19726600**

(43) Veröffentlichungstag der Anmeldung:
**12.09.2001 Patentblatt 2001/37**

(62) Dokumentnummer(n) der früheren Anmeldung(en) nach Art. 76 EPÜ:
**98934858.6 / 0 992 116**

(73) Patentinhaber: **SIEMENS AKTIENGESELLSCHAFT**
**80333 München (DE)**

(72) Erfinder: **Xu, Wen, Dr.**
**82008 Unterhaching (DE)**

(56) Entgegenhaltungen:
- **HAGENAUER J: "SOURCE-CONTROLLED CHANNEL DECODING" IEEE TRANSACTIONS ON COMMUNICATIONS, Bd. 43, Nr. 9, September 1995 (1995-09), Seiten 2449-2457, XP000525669**
- **XU, HAGENAUER AND HOLLMANN: "JOINT SOURCE-CHANNEL DECODING USING THE RESIDUAL REDUNDANCY IN COMPRESSED IMAGES" 1996 IEEE INTERNATIONAL CONFERENCE ON COMMUNICATIONS (ICC), CONVERGING TECHNOLOGIES FOR TOMORROW'S APPLICATIONS DALLAS, JUNE 23 - 27, 1996, Bd. 1, 23. Juni 1996 (1996-06-23), Seiten 142-148, XP000625657 INSTITUTE OF ELECTRICAL & ELECTRONICS ENGINEERS**

EP 1 133 063 B1

## Beschreibung

Die Erfindung betrifft ein Verfahren zum Bearbeiten von mit einem Empfänger empfangenen Daten, bei dem in aufeinanderfolgenden Rahmen über eine Übertragungsstrecke übertragene Daten empfangen werden. Ein Rahmen enthält eine vorgegebene Anzahl von Bitstellen. Die empfangenen Daten werden mit Hilfe eines Metrikinkremente verwendenden Maximum-Aposteriori-Wahrscheinlichkeitsalgorithmus oder Maximum-Likelihood-Algorithmus bearbeitet, wobei der Viterbi-Algorithmus verwendet wird. Die Metrikinkremente für mindestens eine Bitstelle, deren Wert und/oder deren sogenannter Zuverlässigkeitswert von Rahmen zu Rahmen korreliert, werden dabei abhängig von einem für diese Bitstelle ermittelten aktuellen Zuverlässigkeitswert berechnet. Der Zuverlässigkeitswert ist ein Maß für die Wahrscheinlichkeit, daß der Wert der Bitstelle (1) einen vorgegebenen Wert hat.

Ein derartiges Verfahren ist für einen Viterbi-Algorithmus z.B. aus dem Aufsatz "Source-Controlled Channel Decoding" von Joachim Hagenauer in "IEEE Transactions on Communications", Band 43, Nr. 9, September 1995, Seite 2449 bis Seite 2457, bekannt. Wesentliche Teile dieses Aufsatzes sind auch in der Patentschrift DE 42 24 214 C2 enthalten. Insbesondere die Formel (21) des Aufsatzes gibt die Berechnung neuer Metriken $M_k^{(m)}$ aus alten Metriken $M_{k-1}^{(m)}$ und einem zugehörigen Metrikinkrement an. Dabei bezeichnet m einen bestimmten Pfad und k eine bestimmte Bitstelle in einem Rahmen. Beim Berechnen der Metrik $M_k^{(m)}$ wird ein Zuverlässigkeitswert $L(u_k)$ verwendet. Auf den Seiten 2454 und 2455 des genannten Aufsatzes wird zur Bestimmung des Zuverlässigkeitswertes $L(u_k)$ der sogenannte HUK-Algorithmus vorgeschlagen, der auf einem empirischen Modell beruht, bei dem die Zuverlässigkeitswerte L(uk) ähnlich den sogenannten Punkten bei einer deutschen Haftpflichtversicherung für Autos berechnet werden. Aufgrund des empirischen Charakters sind die Schätzungen für die Zuverlässigkeitswerte $L(u_k)$ ungenau. Die Metrikinkremente werden entweder zu bereits berechneten Metriken addiert oder multipliziert.

Der Maximum-Aposteriori-Wahrscheinlichkeitsalgorithmus und der Maximum-Likelihood-Algorithmus sind Algorithmen, die eine über die Übertragungsstrecke übertragene Datenfolge mit Referenzfolgen s vergleichen, und die Referenzfolge s bestimmen, die mit der größten Wahrscheinlichkeit zu der gesendeten Datenfolge gehört. Maximum-Aposteriori-Wahrscheinlichkeit bedeutet, daß die Referenzfolge s gewählt wird, für die die Wahrscheinlichkeit P (s|y) maximal wird, wobei y die empfangene Datenfolge ist. Maximum-Likelihood bedeutet, daß die Referenzfolge s gewählt wird, für die die Wahrscheinlichkeit P (y|s) maximal wird. Die Übertragungsstrecke ist z.B. ein Funkkanal, eine Übertragungsleitung oder auch ein Speichermedium, von dem Daten gelesen werden.

Aus der europäischen Patenanmeldung EP 0 449 327 A2 ist ein rauschunempfindlicher Mehrfach-Empfänger mit mehreren Empfangsantennen bekannt. Die Empfangssignale werden durch ein einziges Sendesignal erzeugt, das über verschiedene Übertragungswege zu den Antennen gelangt. Aus den Empfangssignalen der einzelnen Antennen werden Zweigmetriken für die Durchführung eines Viterbi-Algorithmus berechnet. Vor der Durchführung des Algorithmus werden die zu den Empfangssignalen der einzelnen Antennen berechneten Zweigmetriken gewichtet und verknüpft. Dies führt dazu, daß nach der Durchführung Viterbi-Algorithmus eine Symbolfolge erzeugt wird, die mit einer dem Sendesignal zugrundeliegenden Sende-Symbolfolge gut übereinstimmt.

Es ist Aufgabe der Erfindung, zum Ermitteln der Zuverlässigkeitswerte ein einfaches Verfahren anzugeben, das die aktuellen Zuverlässigkeitswerte möglichst fehlerfrei und genau berechnet.

Diese Aufgabe wird durch ein Verfahren mit den Merkmalen des Patentanspruchs 1 gelöst. Vorteilhafte Ausführungsformen sind in den auf diesen Anspruch rückbezogenen Unteransprüchen angegeben.

Die Erfindung geht von der Überlegung aus, daß die aktuellen Zuverlässigkeitswerte mit einem Optimierungsverfahren sehr genau bestimmt werden könnten. Die Schwierigkeit besteht jedoch darin, daß für die Optimierung zu verwendende Zuverlässigkeitswerte, auf einer mit Fehlern behafteten Beobachtung beruhen. Die Fehler sind auf Störungen bei der Übertragung der Daten über die Übertragungsstrecke und auf fehlerbehaftete Ergebnisse des Viterbi-Algorithmus zurückzuführen. Deshalb wird beim Verfahren nach der Erfindung als Zielfunktion die Summe der Abweichungen eines im wesentlichen fehlerfreien Zuverlässigkeitswertes für einen Rahmen und des für denselben Rahmen ermittelten Zuverlässigkeitswertes definiert. Die Abweichung bezieht sich dabei auf den Betrag der Differenz zwischen dem tatsächlichen, fehlerfreien Zuverlässigkeitswert und dem ermittelten Zuverlässigkeitswert. Die Zielfunktion wird durch das Optimierungsverfahren minimiert, so daß die für die Durchführung des Viterbi-Algorithmus ermittelten Zuverlässigkeitswerte sehr nahe an die fehlerfreien Zuverlässigkeitswerten kommen.

Die Minimierung der Zielfunktion kann beim Verfahren nach der Erfindung trotz unbekannter fehlerfreier Zuverlässigkeitswerte deshalb durchgeführt werden, weil beim Optimierungsverfahren ein mathematisches Modell verwendet wird, das einen Zusammenhang zwischen den auf den Beobachtungen beruhenden Zuverlässigkeitswerten und den fehlerfreien Zuverlässigkeitswerten herstellt. Außerdem werden in dem Modell sogenannte a priori Informationen verwendet, d. h. Informationen, die schon vor der Übertragung der Daten über die Übertragungsstrecke bekannt sind, wie z.B. Informationen über die Korrelation der Daten oder die Korrelation der Zuverlässigkeitswerte in aufeinanderfolgenden Rahmen. In diesem Sinne beeinflußt die Datenquelle die weitere Bearbeitung der Daten. Ist die Bearbeitung z.B. eine Decodierung, so spricht man auch von quellengesteuerter Kanaldecodierung.

Der auf der Beobachtung beruhende Zuverlässigkeitswert liegt bei einem Viterbi-Algorithmus ohne Iteration in der Regel erst mit einer Verzögerung von einem Rahmen vor. Demzufolge muß zur Ermittlung des aktuellen Zuverlässigkeitswertes auf einen beobachteten Zuverlässigkeitswert zurückgegriffen werden, der aus einem bereits bearbeiteten Rahmen für die Bitstelle bestimmt wurde. Wird dagegen ein Viterbi-Algorithmus mit Iteration durchgeführt, so ist bereits im zweiten Iterationsschritt ein auf einer Beobachtung beruhender Zuverlässigkeitswert für den momentan bearbeiteten Rahmen vorhanden. In diesem Fall wird dieser beobachtete Zuverlässigkeitswert zur Ermittlung des aktuellen Zuverlässigkeitswertes verwendet.

Das Verfahren nach der Erfindung liefert gegenüber dem bekannten HUK-Algorithmus bessere Ergebnisse, da mit ihm stark schwankende Quellensignale bearbeitet werden können, bei denen der HUK-Algorithmus nicht in der Lage ist, die Zuverlässigkeitswerte hinreichend genau zu schätzen. Beim Verfahren nach der Erfindung liegen die beim Durchführen des Viterbi-Algorithmus verwendeten Zuverlässigkeitswerte nahe an den tatsächlichen Zuverlässigkeitswerten, so daß die Wahrscheinlichkeit eines Fehlers bei der Pfadauswahl reduziert wird, da die verwendeten Zuverlässigkeitswerte die Pfadauswahl beeinflussen. Eine richtige Pfadauswahl führt z.B. bei einer Decodierung zu einer korrekt decodierten Bitfolge.

In einer Weiterbildung der Erfindung werden die Zuverlässigkeitswerte nach folgender Formel berechnet:

$$L(u_I) = \log \frac{P(u_I = +1)}{P(u_I = -1)}$$

Dabei ist $u_I$ der Wert der Bitstelle, der vorzugsweise "+1" oder "-1" betragen kann. $P(u_I=+1)$ ist die Wahrscheinlichkeit dafür, daß der Wert in der betrachteten Bitstelle 1 "+1" ist. Entsprechend ist $P(u_I=-1)$ die Wahrscheinlichkeit dafür, daß der Wert in der Bitstelle 1 "-1" ist.

Bei einem Verfahren nach einem weiteren Aspekt der Erfindung wird bei der Optimierung nicht mit den Zuverlässigkeitswerten direkt gerechnet, sondern es werden Hilfszuverlässigkeitswerte verwendet, für die vorzugsweise folgende Formel gilt:

$$m(u_I)=P(u_I=+1)-P(u_I=-1).$$

Die Hilfszuverlässigkeitswerte haben gegenüber den Zuverlässigkeitswerten den Vorteil, daß sie für Wahrscheinlichkeiten p zwischen "0" und "1" einen Wertebereich zwischen "+1" und "-1" haben. Die Zuverlässigkeitswerte haben dagegen im angegebenen Funktionsbereich Funktionswerte von "-∞" bis "+∞", so daß Berechnungen in einem beschränktem Zahlenbereich erschwert sind, wie er bei maschinellen Rechnern vorhanden ist. Die Umrechnung von Zuverlässigkeitswerten zu Hilfszuverlässigkeitswerten bzw. von Hilfszuverlässigkeitswerten zu Zuverlässigkeitswerten erfolgt aufgrund einer einfachen mathematischen Beziehung, die z.B. in Form von Tabellenwerten in einen Speicher gespeichert wird.

Durch eine rekursive Optimierung bei der der aktuelle Zuverlässigkeitswert bzw. der aktuelle Hilfszuverlässigkeitswert rekursiv aus dem Zuverlässigkeitswert bzw. dem Hilfszuverlässigkeitswert für den zuletzt bearbeiteten Rahmen berechnet wird, läßt sich der Rechenaufwand bei der Optimierung verringern.

Vorteilhafterweise wird zur Optimierung ein sogenanntes Kalman-Filter eingesetzt, bei dem die Optimierung ebenfalls rekursiv durchgeführt wird. Ein derartiges Filter ist z.B. im Aufsatz "Least-squares estimation: from Gauss to Kalman" von H. W. Sorenson angegeben, der im IEEE Spectrum, Band 7, Seiten 63 bis 68, vom Juli 1970 erläutert ist. Das dem Kalman-Filter zugrundeliegende mathematische Modell berücksichtigt die Tatsache, daß die tatsächlichen Zuverlässigkeitswerte nur indirekt über die auf einer fehlerbehafteten Beobachtung beruhenden Zuverlässigkeitswerte ermittelt werden können. Das Kalman-Filter nutzt weiterhin statistische Eigenschaften der Zuverlässigkeitswerte und der übertragenen Daten aus und verfolgt schnelle Änderung der Werte der übertragenen Daten mit ausreichender Geschwindigkeit.

Das Verfahren nach der Erfindung läßt sich vorteilhaft dann einsetzen, wenn zwischen Bitstellen aufeinanderfolgender Rahmen Korrelationen auftreten. Dies ist z.B. bei Bitstellen für höherwertige Bits von Parametern in einem Rahmen der Fall, der gemäß GSM-Standard bei einem Mobilfunksystem übertragen wird. In einer Weiterbildung des Verfahrens der Erfindung wird die Korrelation in den genannten Bitstellen zur Decodierung dieser Bitstellen ausgenutzt.

Im folgenden werden Ausführungsbeispiele der Erfindung an Hand der Zeichnungen erläutert. Darin zeigen:

Figur 1    ein Blockdiagramm mit wesentlichen Funktionseinheiten für eine Datenübertragung,

Figur 2    zwei zu übertragende Rahmen aus Daten ,

Figur 3    eine schematische Darstellung für eine erste Art der Berechnung eines Hilfszuverlässigkeitswertes in einem Kalman-Filter,

Figur 4      eine schematische Darstellung für eine zweite Art der Berechnung eines Hilfszuverlässigkeitswertes in einem Kalman-Filter,

Figur 5      ein Diagramm der Korrelationskoeffizienten für verschiedene Parameter aus einem GSM-Fullrate-Sprachcodierer, und

Figur 6      ein Diagramm der Korrelationskoeffizienten für die Bitstellen 0 bis 69 in einem GSM-Fullrate codierten Rahmen.

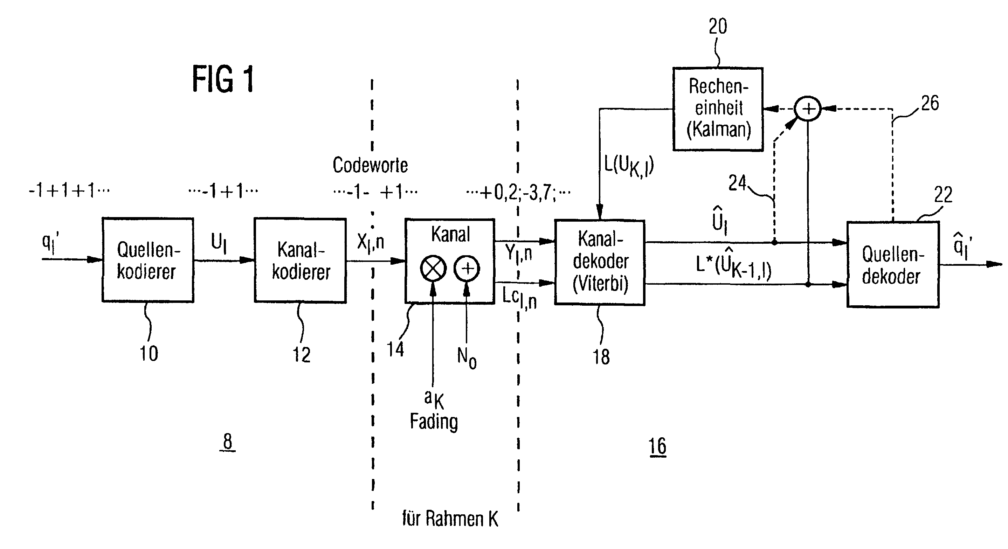

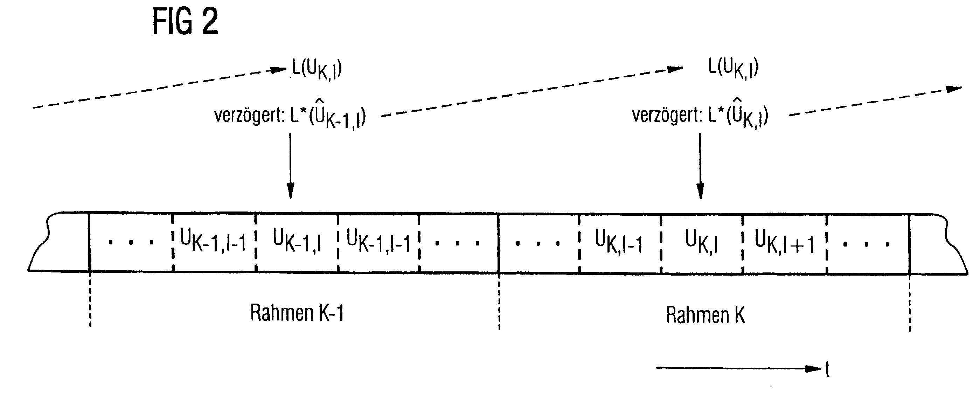

Figur 1 zeigt ein Blockdiagramm mit wesentlichen Funktionseinheiten für eine Datenübertragung. Dabei wird im wesentlichen auf die Übertragung eines Rahmens k bezug genommen, wobei der die natürlichen Zahlen annehmende Index k wegen der besseren Übersicht in Figur 1 und bei der folgenden Erläuterung dieser Figur nur in den Fällen mitgeschrieben wurde, wo eine Unterscheidung der Rahmen k für die Erfindung von Bedeutung ist. Der Aufbau des Rahmens k wird unten anhand der Figur 2 erläutert.

Eine in einem Sender 8 erzeugte Quellsymbolfolge $\{q_{l'}\}$ besteht aus Quellsymbolen $q_{l'}$, die abhängig von den zu sendenden Informationen z.B. die Werte "+1" und "-1" haben. Der Index 1' läuft für die im Rahmen k übertragenen Quellsymbole $q_{l'}$ von 0 bis L'-1, wobei L' die Anzahl von Quellsymbolen $q_{l'}$ je Rahmen k ist. Die Quellsymbolfolge $\{q_{l'}\}$ wird durch einen Quellencodierer 10 komprimiert, z.B. mit einem GSM-Fullrate-Sprachcodierer. Dabei wird eine quellencodierte Folge $\{u_l\}$ aus quellencodierten Symbolen $u_l$ erzeugt. Die quellencodierten Symbole $u_l$ haben entweder den Wert "+1" oder "-1". Der Index 1 läuft innerhalb eines Rahmens von 0 bis L-1, wobei L die Anzahl von quellencodierten Symbolen $u_l$ in einem Rahmen ist. Dabei ist L' üblicherweise größer als L.

Die quellencodierte Folge $\{u_l\}$ wird dann in einem Kanalcodierer 12 gegen Kanalstörungen codiert, wobei z. B. ein Faltungscode verwendet wird. Dabei entsteht eine kanalcodierte Folge $\{x_{l,n}\}$ aus Codeworten $x_l$. Innerhalb der Codeworte $x_l$ werden die Bitstellen durch den Index n bezeichnet, der innerhalb eines Codewortes $x_l$ von Null bis N-1 läuft, wobei N die Anzahl der Bitstellen in einem Codewort $x_l$ ist. Die Bitstellen $x_{l,n}$ der Codeworte $x_l$ haben wiederum entweder den numerischen Wert "+1" oder "-1". Die kanalcodierte Folge $\{x_{l,n}\}$ wird in einem nicht dargestellten Modulator weiterverarbeitet und anschließend über eine Übertragungsstrecke 14 übertragen. Bei der Übertragung treten Störungen auf, z.B. Fading, beschrieben durch einen Fadingfaktor $a_k$, und Rauschen, beschrieben durch den Rauschfaktor $N_0$.

Die Übertragungsstrecke 14 liegt zwischen dem Sender 8 und einem Empfänger 16. Der Empfänger 16 enthält gegebenenfalls eine nicht dargestellte Antenne zum Empfang der über die Übertragungsstrecke 14 übertragenen Signale, eine Abtasteinrichtung, einen Demodulator zum Demodulieren der Signale und einen Entzerrer zum Eliminieren der Intersymbolstörungen. Diese Einrichtungen wurden ebenfalls aus Vereinfachungsgründen in Figur 1 nicht dargestellt. Der Entzerrer gibt Empfangswerte $y_{l,n}$ einer Empfangsfolge $\{y_{l,n}\}$ aus. Die Empfangswerte $y_{l,n}$ haben aufgrund der Störungen bei der Übertragung über die Übertragungsstrecke 14 Werte, die von "+1" und "-1" abweichen, z.B. "+0,2" oder "-3,7".

Die Empfangswerte $y_{l,n}$ werden in einem Kanaldecoder 18 weiter bearbeitet. Die vom Kanalcoder 12 durchgeführte Faltungscodierung wird im Kanaldecoder 18 wieder rückgängig gemacht, wobei Übertragungsfehler korrigiert werden sollen. Bei der Faltungsdecodierung wird z.B. der bekannte Viterbi-Algorithmus verwendet. Zur Durchführung des Viterbi-Algorithmus wird dem Kanaldecodierer 18 auch eine Kanalzustandsinformation $Lc_{l,n}$ zugeführt. Bei der Durchführung des Viterbi-Algorithmus im Kanaldecoder 18 wird eine sogenannte Metrik $M_l^{(m)}$ des Pfades m für die Bitstelle 1 nach der folgenden Formel berechnet:

$$M_l^{(m)} = M_{l-1}^{(m)} + \sum_{n=0}^{N-1} \hat{x}_{l,n}^{(m)} Lc_{l,n} y_{l,n} + \hat{u}_l^{(m)} L\left(u_{k,l}\right) \qquad (1),$$

wobei $M_{l-1}^{(m)}$ die alte Metrik des Pfades m ist, d.h. für die Bitstelle l-1, $\hat{x}_{l,n}^{(m)}$ die Bits des zum Pfad m und zur Bitstelle l gehörenden Codewortes sind, $\hat{u}_l^{(m)}$ das zum Codewort $\hat{x}_l^{(m)}$ gehörende decodierte Symbol und $L(u_{k,l})$ ein ermittelter Zuverlässigkeitswert ist, der ein Maß für diejenige Wahrscheinlichkeit ist, daß das quellencodierte Symbol $u_l$ gleich "-1" ist.

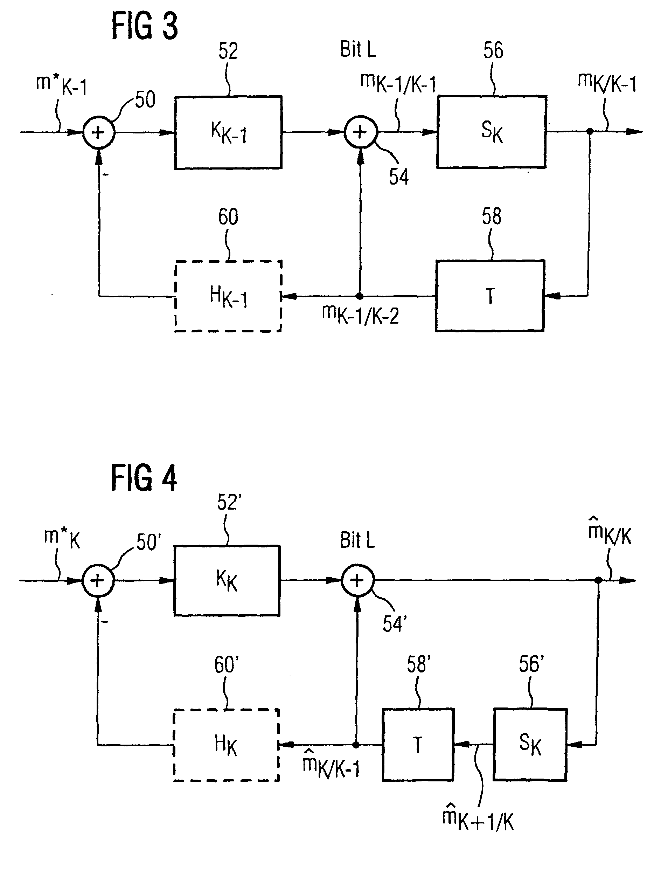

Der Zuverlässigkeitswert $L(u_{k,l})$ wird in einer Recheneinheit 20 ermittelt, deren Aufbau unten an Hand der Figuren 3 und 4 erläutert wird.

Die Kanalzustandsinformation $Lc_{l,n}$ wird implizit bestimmt, indem eine sogenannte Kanal-Soft-Ausgabe ermittelt wird, die dem Produkt aus der Kanalzustandsinformation $Lc_{l,n}$ und dem jeweiligen Empfangswert $y_{l,n}$ entspricht. Für die Kanal-Soft-Ausgabe gilt die Beziehung:

$$L_c y = L(x/y) - L(x) \qquad (2),$$

worin $L(x/y)$ ein Zuverlässigkeitswert ist, der angibt, mit welcher Wahrscheinlichkeit in der jeweiligen Bitstelle des Codewort der Wert x auftritt, wenn der Empfangswert y empfangen wurde, und $L(x)$ ein Zuverlässigkeitswert ist, der angibt, wie sicher der Wert x bestimmt werden kann. Für einen sogenannten Gauß-/Fading-Kanal gilt $L_C=4aE_S/N_0$, wobei a der Fadingfaktor und $E_S/N_0$ das Signal-Rausch-Verhältnis sind.

Der Kanaldecoder 18 erzeugt eine empfangene quellencodierte Folge $\{\hat{u}_l\}$ aus quellencodierten bzw. kanaldecodierten Empfangssymbolen $\hat{u}_l$. Zu jedem quellencodierten Empfangssymbol $\hat{u}_{k-1,l}$ gehört ein beobachteter Zuverlässigkeitswert $L^*(\hat{u}_{k-1,l})$, der eine sogenannte Soft-Ausgabe des Kanaldecodierers 18 ist. Der Zuverlässigkeitswert $L^*(\hat{u}_{k-1,l})$ ist ein Maß für die Zuverlässigkeit, mit der das quellencodierte Empfangssymbol $\hat{u}_l$ durch den Kanaldecoder 18 bestimmt werden konnte. Der durch den Kanaldecoder 18 erzeugte Zuverlässigkeitswert $L^*(\hat{u}_{k-1,l})$ wird zur Unterscheidung von dem durch die Recheneinheit 20 berechneten Zuverlässigkeitswert $L(u_{k,l})$ im folgenden auch als der auf einer Beobachtung beruhende Zuverlässigkeitswert bzw. als der beobachtete Zuverlässigkeitswert bezeichnet. Der beobachtete Zuverlässigkeitswert $L^*(\hat{u}_{k-1,l})$ wird durch den Kanaldecoder 18 erst mit einer Verzögerung von einem Rahmen k erzeugt. Diese Verzögerung wird durch den Index k-1 deutlich. Bei dem im folgenden erläuterten Ausführungsbeispiel der Erfindung wird der beobachtete Zuverlässigkeitswert $L^*(\hat{u}_{k-1,l})$ in der Recheneinheit 20 verwendet, um den Zuverlässigkeitswert $L(u_{k,l})$ für den aktuell bearbeiteten Rahmen k zu ermitteln.

Die quellencodierten Empfangssymbole $\hat{u}_{k-1,l}$ und/oder die beobachteten Zuverlässigkeitswerte $L^*(\hat{u}_{k-1,l})$ werden in einen Quellendecoder 22 eingegeben, der die quellencodierten Empfangssymbole $\hat{u}_l$ decomprimiert, wobei eine Quellsymbolfolge $\{q_{l'}\}$ aus empfangenen Quellsymbolen $q_{l'}$ entsteht.

Zwei gestrichelte Pfeile 24 und 26, die an einer Addiereinheit 28 enden, sollen darauf hinweisen, daß in der Recheneinheit 20 neben den Zuverlässigkeitswerten $L^*(\hat{u}_{k-1,l})$ oder anstelle dieser Zuverlässigkeitswerte die quellencodierten Empfangssymbole $\hat{u}_l$ und/oder Informationen verwendet werden, die im Quellendecoder 22 bei der Decodierung erzeugt werden. Die Recheneinheit 20 ermöglicht letztlich, daß die empfangene Quellsymbolfolge $\{q_{l'}\}$ im wesentlichen mit der gesendeten Quellsymbolfolge $\{q_l'\}$ übereinstimmt und somit der Einfluß von Kanalstörungen bei der Übertragung hinreichend gut korrigiert wird.

Figur 2 zeigt zwei Rahmen, nämlich den aktuellen Rahmen k und den vorherigen Rahmen k-1, aus quellencodierten Symbolen $u_l$. Zu jedem Rahmen k, k-1 gehören L quellencodierte Empfangssymbole $u_l$, so daß der Index 1 von 0 bis L-1 läuft. Ein Zusammenhang zwischen den Rahmen k, k-1, k-2 usw. wird erst durch die Recheneinheit 20 gemäß Figur 1 hergestellt. Dabei wird die Tatsache genutzt, daß zwischen bestimmten quellencodierten Symbolen, z. B. dem Symbol $u_{k,l}$ und $u_{k-1,l}$, bzw. zwischen ihren Zuverlässigkeitswerten $L(u_{k,l})$ und $L(u_{k-1,l})$ aufeinanderfolgender Rahmen k-1, k eine ausgeprägte Korrelation auftritt. Diese Korrelation wird bei der Erfindung durch ein mathematisches Modell wiedergegeben, auf dessen Grundlage die Zuverlässigkeitswerte $L(u_{k,l})$ ermittelt werden.

Werden die Metrikinkremente $M_l^{(m)}$ für die zum Empfangssymbol $\hat{u}_{k-1,l}$ gehörenden Zustände berechnet, so wird jeweils der Zuverlässigkeitswert $L(u_{k-1,l})$ gemäß Formel (1) berücksichtigt. Der Zuverlässigkeitswert $L^*(\hat{u}_{k-1,l})$ ist zu diesem Zeitpunkt noch nicht bekannt. Werden danach die Metriken $M_l^{(m)}$ für die zum Empfangssymbol $\hat{u}_{k,l}$ gehörenden Zustände ermittelt, so liefert die Recheneinheit 20, vgl. Figur 1, einen Zuverlässigkeitswert $L(u_{k,l})$, der aus dem zu diesem Zeitpunkt bekannten Zuverlässigkeitswert $L^*(\hat{u}_{k-1,l})$ berechnet worden ist. Somit steht trotz der Verzögerung um einem Rahmen bis zum Erzeugen des auf einer Beobachtung beruhenden Zuverlässigkeitswertes $L^*(\hat{u}_{k,l})$ ein Zuverlässigkeitswert $L(u_{k,l})$ für den Rahmen k mit ausreichender Genauigkeit zur Verfügung.

Figur 3 zeigt eine schematische Darstellung für eine erste Art der Berechnung von Hilfszuverlässigkeitswerten in einem Kalman-Filter. Die Hilfszuverlässigkeitswerte werden weiter unten erläutert, nachdem zunächst das Kalman-Filter näher erläutert worden ist.

Im folgenden wird eine Schreibweise verwendet, die sich an die bei der Erläuterung eines Kalman-Filters in dem Aufsatz "Least-squares estimation: from Gauss to Kalman" von H. W. Sorenson verwendete Schreibweise anlehnt, vgl. IEEE Spectrum, Band 7, Seiten 63 bis 68, Juli 1970. Das dort in den Gleichungen (11') und (10') verwendete mathematische Modell ist mehrdimensional. Zur Erläuterung eines Ausführungsbeispiels der Erfindung wird jedoch auf den einfacheren Fall eines eindimensionalen Modells zurückgegriffen. In diesem Fall haben Vektoren nur eine Komponente und sind somit Skalare. Es ergibt sich folgendes Systemmodell:

$$x_k = \rho_k x_{k-1} + w_k \qquad (3),$$

wobei $x_k$ der Zustand zum Zeitpunkt k, $x_{k-1}$ der Zustand zum Zeitpunkt k-1, $\rho_k$ der Korrelationskoeffizient zwischen $x_k$ und $x_{k-1}$ sowie $w_k$ eine Systemstörung zum Zeitpunkt k sind. Dieses Systemmodell wird zur Modellierung eines sogenannten Markovschen Prozesses erster Ordnung verwendet. Eine andere oft verwendete Bezeichnung für ein solches Systemmodell ist "autoregressives Modell erster Ordnung".

Das zugehörige Meßmodell lautet:

$$z_k = x_k + v_k \tag{4}$$

worin $z_k$ ein Meßwert zum Zeitpunkt k und $v_k$ eine Meßstörung zum Zeitpunkt k sind. Ein mit $x_k$ zu multiplizierender Meßfaktor $H_k$ hat den Wert "1" und wurde deshalb in Formel (4) nicht mitgeschrieben. Die Störungen $w_k$ und $v_k$ entstehen durch sogenanntes weißes Rauschen und haben den Mittelwert Null. Weiterhin werden die Varianz von $w_k$ als $Q_k$ und die Varianz von $v_k$ als $R_k$ bezeichnet.

Ausgehend von den Modellen nach den Formeln (3) und (4) ist der Kalman-Filter-Algorithmus in Übereinstimmung mit H. W. Sorenson durch die folgenden Formeln definiert:

$$\hat{x}_{k/k-1} = \rho_k \hat{x}_{k-1/k-1} \tag{5}$$

$$P_{k/k-1} = \rho_k^2 P_{k-1/k-1} + Q_{k-1} \tag{6}$$

$$K_k = \frac{P_{k/k-1}}{P_{k/k-1} + R_k} \tag{7}$$

$$\hat{x}_{k/k} = \hat{x}_{k/k-1} + K_k(z_k - \hat{x}_{k/k-1}) \tag{8}$$

$$P_{k/k} = (1 - K_k)P_{k/k-1} \tag{9}$$

worin $\hat{x}_k$ eine Schätzung für den Zustand $x_k$ und $P_k$ die Kovarianz des Fehlers $e_k = x_k - \hat{x}_k$ ist. Bei den Indizes gibt der erste Index den jeweiligen Zeitpunkt k bzw. k-1 an, zu dem die indizierte Größe berechnet wird bzw. wurde. Der durch einen Schrägstrich abgetrennte Index gibt an, zu welchem Zeitpunkt die zur Berechnung der jeweiligen indizierten Größe erforderlichen Werte zur Verfügung stehen. Im folgenden wird auch eine Schreibweise verwendet, bei der der zweite Index weggelassen wird, falls er zum Verständnis nicht notwendig ist.

Die Varianzen $Q_k$, $R_k$ sowie der Korrelationskoeffizient $\rho_k$ sind vorzugsweise konstant und werden zu Beginn der Filterung vorgegeben. Bei der Vorgabe werden vorteilhaft Meßwerte berücksichtigt, die zuvor gemessen worden sind.

Der in den Formeln (5) bis (9) angegebene Kalman-Filter-Algorithmus ist im Sinne des mittleren quadratischen Fehlers optimal, d.h., die Summe der Abweichungen zwischen tatsächlichen Zuständen $x_k$ und den geschätzten Zuständen $\hat{x}$ ist minimal.

Durch Einsetzen der Formel (8) in die Formel (5) ergibt sich eine sogenannte Prädiktenschätzung für $\hat{x}_{k+1/k}$:

$$\hat{x}_{k+1/k} = \rho_{k+1}\left(\hat{x}_{k/k-1} + K_k(z_k - \hat{x}_{k/k-1})\right) \tag{10}$$

Eine Schätzung $\hat{x}_{k+1/k+1}$ aufgrund eines zum Bearbeitungszeitpunkt k+1 vorhandenen Meßwertes $z_{k+1}$ ergibt sich durch Einsetzen der Formel (5) in die Formel (8):

$$\hat{x}_{k+1/k+1} = \rho_{k+1}\hat{x}_{k/k} + K_{k+1}(z_{k+1} - \rho_{k+1}\hat{x}_{k/k}) \tag{11}$$

Die Schätzwerte $\hat{x}_{k+1}$ sind betragsmäßig kleiner oder gleich dem maximalen Betrag der Meßwerte $z_k$. Somit

arbeitet der Kalman-Filter-Algorithmus stabil. Durch den neuen Meßwert $z_k$ bzw. $Z_{k+1}$ entsteht ein Beitrag $(z_k-\hat{x}_{k/k-1})$ bzw. $(z_{k+1}-\rho_{k-1}x_{k/k})$.

Durch mathematische Umstellungen, bei denen in den Formeln (7) und (9) die Kovarianz $P_{k/k-1}$ mit Hilfe der Formel (6) ersetzt wird, und bei denen anschließend die Kovarianz $P_{k-1/k-1}$ eliminiert wird, ergibt sich die folgende Formel für die Berechnung des Verstärkungsfaktors K:

$$K_{k+1} = \frac{Q_k + {}_{\rho k+1}{}^2 R_k K_k}{Q_k + R_{k+1} + \rho_{k+1}{}^2 R_k K_k} \tag{12}.$$

Aus der Formel (12) ergibt sich, daß, wenn die Meßstörungen $v_k$ im Vergleich zu den Systemstörungen $w_k$ sehr klein sind, und somit $R_k$ wesentlich kleiner als $Q_k$ ist, der Verstärkungsfaktor $K_k$ etwa den Wert Eins annimmt. Hat der Verstärkungsfaktor $K_k$ den Wert Eins, so wird gemäß den Formeln (10) und (11) der optimale Schätzwert $x_{k+1}$ nur durch den aktuellen Meßwert $z_k$ bzw. $z_{k+1}$ bestimmt. Sind dagegen die Systemstörungen $w_k$ im Vergleich zu den Meßstörungen $v_k$ gering, dann geht der Verstärkungsfaktor $K_k$ gegen Null. Aus den Gleichungen (10) und (11) folgt für einen Verstärkungsfaktor $K_k$ von etwa Null, daß der optimale Schätzwert $x_{k+1}$ nur vom vorhergehenden Schätzwert $x_k$ abhängt. Diese Eigenschaften des Kalman-Filters gewährleisten eine gute Schätzung der tatsächlichen Zustände $x_k$, die fehlerfrei sind.

Die Gleichung (11) kann auch wie folgt geschrieben werden:

$$\hat{x}_{k+1/k+1} = (1 - K_{k+1})\rho_{k+1}\hat{x}_{k/k} + K_{k+1}z_k = \cdots$$
$$= h_0\hat{x}_{0/0} + \sum_{j=1}^{k+1} h_j z_j \tag{13},$$

wobei $h_j$ die von $z_j$ (j=1, ..., k+1) unabhängigen Filterkonstanten sind. Somit ist der Schätzwert $\hat{x}_{k+1}$ eine lineare Kombination von allen bisher vorhandenen Meßwerten $z_k$. Aus den Gleichungen (10), (11) und (13) läßt sich entnehmen, daß im Schätzwert $x_{k+1}$ sowohl die statistische Korrelation (Statistik erster Ordnung) als auch die Wertverteilung (Statistik nullter Ordnung) der Meßwerte $z_k$ berücksichtigt wird.

Die oben angegebenen Formeln können unmittelbar zur Berechnung der Zuverlässigkeitswerte $L(u_{k,l})$ verwendet werden, wenn $\hat{x}_{k+1}$ durch $L(u_{k,l})$ und $z_k$ durch $L * (\hat{u}_{k,l})$ ersetzt werden. Jedoch ist es aus den im folgenden genannten Gründen zweckmäßig, anstelle der Zuverlässigkeitswerte $L(u_{k,l})$ und $L * (\hat{u}_{k,l})$ Hilfszuverlässigkeitswerte $m(u_{k,l})$ und $m*(\hat{u}_{k,l})$ zu verwenden, die sich z.B. aus einer Linearisierung der stark nichtlinearen Abhängigkeit der Zuverlässigkeitswerte $L(u_{k,l})$ von einer Wahrscheinlichkeit p ergeben.

Für die Zuverlässigkeitswerte gilt allgemein folgende Definition:

$$L(u_l) = \log \frac{P(u_l = +1)}{P(u_l = -1)} = \log \frac{1 - p}{p} \tag{14}.$$

Dabei wird $u_l$ als Zufallsvariable mit den Elementen {+1, -1} angesehen. $P(u_l=-1)=p$ ist die Wahrscheinlichkeit dafür, daß $u_l$ den Wert "-1" hat. $P(u_l=+1)=1-p$ ist dagegen die Wahrscheinlichkeit, daß $u_l$ den Wert "+1" hat. Die Abkürzung "log" kennzeichnet den natürlichen Logarithmus. Die Zuverlässigkeitswerte werden auch als Softwerte oder als logarithmisches Wahrscheinlichkeitsverhältnis bezeichnet.

Gemäß der Definition (14) ist der Zuverlässigkeitswert eine reelle Zahl im Bereich von $[-\infty, +\infty]$. Klassifiziert man $u_l$ an Hand der Werte $L(u_l)$ als "+1" oder "-1", dann gibt das Vorzeichen $\text{sign}(L(u_l))$ die sogenannte Hard-Entscheidung und der Betrag $|L(u_l)|$ die Zuverlässigkeit der Entscheidung an, die auch als Soft-Wert bezeichnet wird.

Betrachtet man die oben angegebene Formel (1) zur Berechnung der Metriken $M_k^{(m)}$, so wird diese allein durch $L(u_{k,l})$ bestimmt, wenn der Zuverlässigkeitswert gegen "$+\infty$" oder "$-\infty$" geht. Dies ist, wie aus Formel (14) zu entnehmen, für p gegen Null bzw. p gegen Eins der Fall. Außerdem ist bei einer Realisierung mit einem Prozessor die Umsetzung der log-Funktion oft störend. Bei einem Ausführungsbeispiel der Erfindung wird zur Beseitigung dieser Nachteile die Beziehung zwischen p und L(uk) linear approximiert:

$$L(u_k) \approx \bar{L}(u_k) \equiv K(1 - 2p) = Km(u_k) \tag{15}.$$

Wobei $\bar{L}(u_k)$ die approximierte Funktion ist, K eine Konstante und $m(u_k)$ die bereits erwähnten Hilfszuverlässigkeitswerte sind. Die Konstante K hat den numerischen Wert "2", so daß die Ableitung der Funktion $L(u_k)$ nach der Wahrscheinlichkeit p für die Wahrscheinlichkeit p=0,5 gleich der Ableitung der Funktion $\bar{L}(u_k)$ nach der Wahrscheinlichkeit p an der Stelle p=0,5 ist.

Für die Hilfszuverlässigkeitswerte $m(u_k)$ gilt folgende Beziehung:

$$m(u_k) = 1 - 2p = (-1)p + (+1)(1 - p) = E\{u_k\} \tag{16}.$$

Aus dieser Formel ist zu entnehmen, daß die Hilfszuverlässigkeitswerte $m(u_k)$ die Mittelwerte von $u_k$ sind.

Der Zusammenhang zwischen den Hilfszuverlässigkeitswerten und den Zuverlässigkeitswerten ergibt sich aus den Formeln (14) und (16) zu:

$$m(u_k) = \tanh \frac{L(u_k)}{2} \tag{17},$$

bzw. zu:

$$L(u_k) = \log \frac{1 + m(u_k)}{1 - m(u_k)} \tag{18}.$$

Der Hilfszuverlässigkeitswert $m(u_k)$ hat eine ähnliche Bedeutung wie der Zuverlässigkeitswert $L(u_k)$, d.h. das Vorzeichen $\text{sign}(m(u_k))$ ist die sogenannte Hard-Entscheidung und der Betrag $|m(u_k)|$ ist die Zuverlässigkeit der Entscheidung - die sogenannte Soft-Entscheidung. Gemäß der Formel (15) bzw. (17) wird der vom Kanaldecoder 18 vgl. Fig. 1, erzeugte beobachtete Zuverlässigkeitswert $L^*(\hat{u}_{k-1,l})$ z.B. mit Hilfe einer Tabelle in einen Hilfszuverlässigkeitswert $m(u_{k-1,l})$ umgewandelt. Der von der Recheneinheit 20, vgl. Figur 1, ermittelte Hilfszuverlässigkeitswert $m(u_{k,l})$ wird dann ebenfalls unter Verwendung einer Tabelle in den Zuverlässigkeitswert $L(u_{k,l})$ umgewandelt. Die Approximation der Zuverlässigkeitswerte $L(u_k)$ durch die Hilfszuverlässigkeitswerte $m(u_k)$ gemäß Gleichung (15) führt in der Praxis ebenfalls zu guten Ergebnissen.

Bei einem Ausführungsbeispiel der Erfindung mit Hilfszuverlässigkeitswerten $m_k$, wobei die Abhängigkeit von $u_k$ nicht mehr mitgeschrieben wird, ergeben sich für den Kalman-Filter aus den Gleichungen (10) und (12) die folgende Berechnungsvorschrift:

$$m_{k/k-1} = \rho_k \left( m_{k-1/k-2} + K_{k-1} \left( m^*_{k-1} - m_{k-1/k-2} \right) \right) \tag{19}$$

$$K_{k-1} = \frac{\sigma^2_{w,k-2} + \rho^2_{k-1}\sigma^2_{v,k-2}K_{k-2}}{\sigma^2_{w,k-2} + \sigma^2_{v,k-1} + \rho^2_{k-1}\sigma^2_{v,k-2}K_{k-2}} \tag{20}.$$

Wobei $\sigma^2_{w,k}$ der bereits erwähnten Varianz $Q_k$ und $\sigma^2_{v,k}$ der ebenfalls erwähnten Varianz $R_k$ entspricht.

Figur 3 zeigt in einem Blockschema die Berechnungen gemäß Formel (19). Mit einer Subtrahiereinheit 50 wird der in Formel (19) in der inneren Klammer stehende Ausdruck $(m^*_{k-1} - m_{k-1/k-2})$ berechnet. Das Ergebnis wird in einer Multipliziereinheit 52 mit dem Verstärkungsfaktor $K_{k-1}$ multipliziert, der gemäß Formel (20) berechnet worden ist. Zum Ergebnis der Multiplikation wird in einer Addiereinheit 54 der Hilfszuverlässigkeitswert $m_{k-1/k-2}$ addiert, womit der Ausdruck innerhalb der äußeren Klammer in Formel (19) bestimmt ist. Anschließend wird das Ergebnis der Berechnung dieses Ausdrucks in einer Multipliziereinheit 56 mit dem Korrelationsfaktor $\rho_k$ multipliziert. Das Ergebnis der Multiplikation ist der Hilfszuverlässigkeitswert $m_{k/k-1}$, der, wie bereits erwähnt, in einen Zuverlässigkeitswert umgewandelt wird, bevor er vom Kanaldecoder 18 (vgl. Fig. 1) verwendet wird.

Eine Verzögerungseinheit 58 erzeugt aus dem Hilfszuverlässigkeitswert $m_{k/k-1}$ durch eine Verzögerung um einen Rahmen den Hilfszuverlässigkeitswert $m_{k-1/k-2}$ für den nächsten Bearbeitungsschritt. In Figur 3 ist eine Multiplizereinheit 60 angedeutet, in der der Hilfszuverlässigkeitswert $m_{k-1/k-2}$ mit dem Meßfaktor $H_{k-1}$ multipliziert wird, bevor er in der Subtrahiereinheit 50 verwendet wird. Der Meßfaktor $H_{k-1}$ hat jedoch wie oben erwähnt im Ausführungsbeispiel den Wert Eins.

In einem anderen Ausführungsbeispiel mit Hilfszuverlässigkeitswerten ist zum Zeitpunkt k bereits der Hilfszuverlässigkeitswert $m^*_k$ bekannt, z.B. wenn eine iterative Decodierung durchgeführt wird. In diesem Fall gelten für das Kalman-Filter in Übereinstimmung mit den Formeln (11) und (12) die beiden folgenden Formeln:

$$m_{k/k} = \rho_k m_{k-1/k-1} + K_k\left(m^*_k - \rho_k m_{k-1/k-1}\right) \tag{21}$$

$$K_k = \frac{\sigma^2_{w,k-1} + \rho^2_k \sigma^2_{v,k-1} K_{k-1}}{\sigma^2_{w,k-1} + \sigma^2_{v,k} + \rho^2_k \sigma^2_{v,k-1} K_{k-1}} \tag{22}$$

Figur 4 zeigt die Berechnung der Formel (21). Die Darstellung in der Figur 4 entspricht im wesentlichen der Darstellung in der Figur 3, so daß bereits erläuterte Funktionseinheiten nicht noch einmal erläutert werden, jedoch zur Unterscheidung die zugehörigen Bezugszeichen einem hochgestellten Strich erhalten. In Figur 4 ist im Vergleich zur Figur 3 der Index k-1 durch den Index k ersetzt.

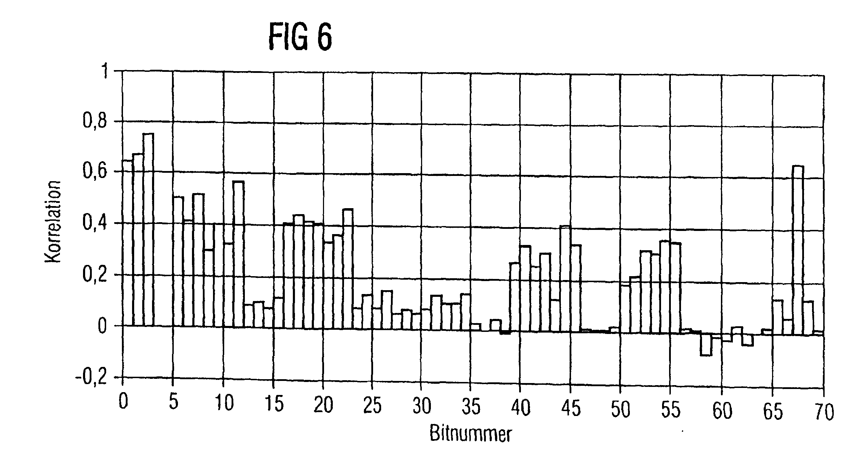

Als Anfangsbedingungen werden in den Ausführungsbeispielen nach Figur 3 oder Figur 4 z.B. gewählt: $m_{0/-1}=m_{0/0}=0$ und $K_0=0$. Die Varianzen $\sigma^2_{w,k}$ und $\sigma^2_{v,k}$ werden aufgrund von Meßwerten vorgegeben. Der Korrelationskoeffizient $\rho_k$ wird ebenfalls aufgrund von Meßwerten vorgegeben, die z.B. mit Hilfe der unten erläuterten Figur 6 ermittelt werden. Die Varianzen $\sigma^2_{w,k}$ und $\sigma^2_{v,k}$ sowie der Korrelationskoeffizient $\rho_k$ können auch während des Filterungsprozesses nach vorgegebenen, gegebenenfalls experimentell bestimmten Funktionen dynamisch berechnet werden.

In den Figuren 3 und 4 ist jeweils ein Kalman-Filter für eine Bitstelle 1 eines Rahmens k, vgl. Figur 2 gezeigt. In der Regel gibt es mehrere Bitstellen 1, die von Rahmen zu Rahmen korrelieren. In diesem Fall wird für jede dieser Bitstellen 1 ein Kalman-Filter gemäß Figur 3 oder gemäß Figur 4 in der Recheneinheit 20 verwendet, vgl. Figur 1.

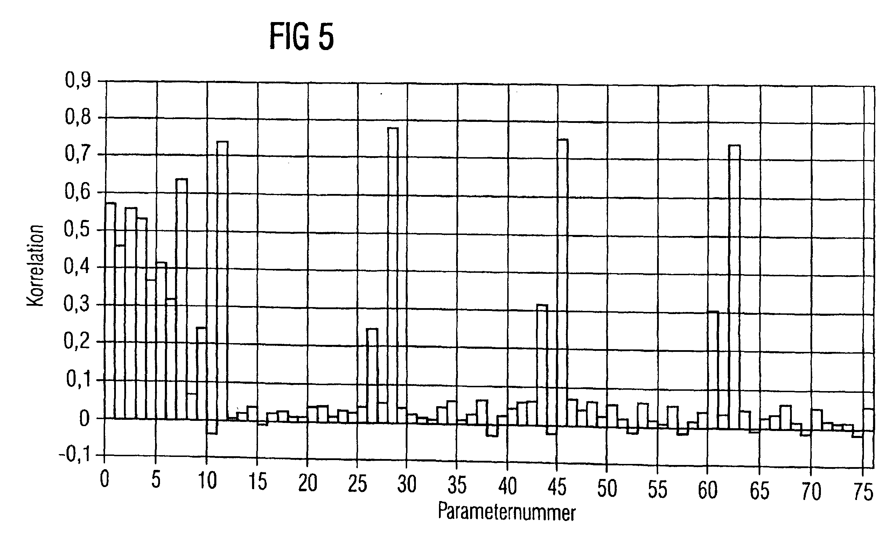

Figur 5 zeigt ein Diagramm, bei dem auf der Abszissenachse die Korrelationskoeffizienten für auf der Ordinatenachse abgetragene Parameternummern 0 bis 75 gezeigt sind. Parameter mit den Nummern 0 bis 75 entsprechen den durch einen GSM-Fullrate-Sprachcoder generierten Parametern, vgl. GSM-Recommendation 06.10 "European digital cellular telecommunications system; Full rate speech transcoding", 1995. Der GSM-Fullrate-Sprachcoder ist z. B. der Quellencodierer 10, vgl. Figur 1.

Die Parameter 0 bis 7 sind die sogenannten LAR-Koeffizienten (logarithmical area ratio), die bei der LPC-Analyse erzeugt werden (linear prediction coding). Die Korrelation dieser Koeffizienten ist durchgängig größer als 0,3. Auch die Parameter Nr. 9, 26, 43 und 60, die Ähnlichkeitsmaße b für die sogenannte LTP sind (long term prediction), haben eine Korrelation, die größer als 0,2 ist. In jedem Rahmen gibt es außerdem vier $X_{MAX}$-Koeffizienten aus der sogenannten RPE-Analyse (regular pulse exciting), die sich von Rahmen zu Rahmen nur wenig ändern und einen Korrelationskoeffizienten größer als 0,7 haben. Die Korrelationen der genannten Parameter treten auch in den höherwertigen Bitstellen auf, in denen diese Parameter übertragen werden.

Figur 6 zeigt ein Diagramm der Korrelationskoeffizienten für die Bitstellen 0 bis 69 in einem GSM-Rahmen. Die Werte vieler Bitstellen haben eine beachtliche Inter-Rahmen-Korrelation, d.h. der Korrelationskoeffizient zwischen $u_k$ und $u_{k-1}$ ist größer als 0,3. An Hand der in Gleichung (16) gezeigten Mittelwertbildung ist zu erkennen, daß der Korrelationskoeffizient $\rho_k$ zwischen $m(u_k)$ und $m(u_{k-1})$ noch deutlich größer sein muß als der Korrelationskoeffizient zwischen $u_k$ und $u_{k-1}$, für den genannten Wert typischerweise 0,8 bis 0,9, so daß das mathematische Modell der Formeln (3) den tatsächlichen Verhältnissen entspricht, und die mit dem Kalman-Filter erzeugten Zuverlässigkeitswerte $L(u_{k,l})$ zu einer Verbesserung des Decodiervorgangs führen.

In einem weiteren Ausführungsbeispiel der Erfindung wird anstelle des in den Formeln (3) und (4) angegebenen eindimensionalen Modells ein mehrdimensionales Modell verwendet. In diesem Fall gilt die im bereits genannten Aufsatz von Sorensen angegebene Vektorschreibweise. Das mehrdimensionale Modell wird insbesondere dann eingesetzt, wenn neben den Inter-Rahmen-Korrelationen auch Intra-Rahmen-Korrelationen berücksichtigt werden.

Die Berechnung der Zuverlässigkeitswerte bzw. der Hilfszuverlässigkeitswerte kann auch ohne Optimierungsverfahren mit etwas eingeschränkter aber doch für viele Zwecke ausreichender Genauigkeit ermittelt werden. Dabei wird der oben in Formel (16) angegebene Zusammenhang genutzt, indem die Hilfszuverlässigkeitswerte $m(u_k)$ nach der folgenden Formel ermittelt werden:

$$m(u_k) = E\{u_k\} \approx \overline{u}_k = \frac{1}{N}\sum_{j=1}^{N} \hat{u}_{k-j} \qquad (23)$$

wobei N eine vorgegebene Anzahl von Rahmen ist, über die eine sogenannte Fensterung erfolgt, d.h. nur die quellencodierten Empfangssymbole $\hat{u}_{k,l}$ der letzten N-Rahmen werden berücksichtigt. Durch diese Maßnahme werden auch schnelle Änderungen des zu schätzenden Signals erfaßt.

Anstelle der Empfangssymbole $\hat{u}_k$ können auch die zugehörigen Hilfszuverlässigkeitswerte $m(u_k)$ oder $m^*(\hat{u}_k)$ verwendet werden. Die ermittelten Hilfszuverlässigkeitswerte $m(u_k)$ werden dann wie oben erläutert weiter bearbeitet.

Die Formel (23) kann mittels der Definition der Hilfszuverlässigkeitswerte, nämlich m=1-2p auch folgendermaßen ausgedrückt werden:

$$\hat{p}=\frac{\text{Anzahl der Bits } \hat{u}_{k-j} = -1 \; (j = 1,2,...,N)}{N} \qquad (24)$$

Anhand der letzten N-decodierten Empfangssymbole $\hat{u}_{k-1}$, $\hat{u}_{k-2}$, ..., $\hat{u}_{k-N}$ erfolgt zunächst die Bestimmung der Wahrscheinlichkeit p als die relative Häufigkeit $\hat{p}$ von Werten "-1". Danach wird der Zuverlässigkeitswert $L(u_k)$ mittels der Formel (14) direkt berechnet, wobei die Wahrscheinlichkeit durch die genäherte Wahrscheinlichkeit $\hat{p}$ zu ersetzen ist.

**Patentansprüche**

1. Verfahren zum Bearbeiten von durch einen Empfänger (16) empfangenen Daten,

   bei dem in aufeinanderfolgenden Rahmen (k) über eine Übertragungsstrecke (14) übertragene Daten empfangen werden, wobei ein Rahmen (k) eine vorgegebene Anzahl von Bitstellen (1) enthält,

   bei dem die empfangenen Daten mit Hilfe eines Metrikinkremente verwendenden Maximum-Aposteriori-Wahrscheinlichkeitsalgorithmus oder Maximum-Likelihood-Algorithmus bearbeitet werden,

   wobei die Metrikinkremente für mindestens eine Bitstelle (1), deren Wert und/oder Zuverlässigkeitswert ($L(u_{k,l})$) von Rahmen (k) zu Rahmen (k-1) korreliert, abhängig von einem für den aktuell bearbeiteten Rahmen (k) ermittelten aktuellen Zuverlässigkeitswert ($L(u_{k,l})$) berechnet werden, der ein Maß für die Wahrscheinlichkeit ist, daß der Wert der Bitstelle (1) fehlerfrei bestimmt werden kann,
   und bei dem zum Ermitteln des aktuellen Zuverlässigkeitswerts ($L(u_{k,l})$) mindestens ein beobachteter Zuverlässigkeitswert ($L^*(\hat{u}_{k-1,l}),L^*(\hat{u}_{k,l})$) verwendet wird, der aus einem bereits bearbeiteten Rahmen (k-1) oder aus dem aktuell bearbeiteten Rahmen (k) für die Bitstelle (1) bestimmt wird,
   **dadurch gekennzeichnet, daß** unter Verwendung einer genauen Umrechnungsfunktion oder einer Approximationsfunktion aus dem beobachteten Zuverlässigkeitswert ($L^*(\hat{u}_{k-1,l})$) ein beobachteter Hilfszuverlässigkeitswert ($m^*(\hat{u}_{k-1,l})$) ermittelt wird,
   daß ein aktueller Hilfszuverlässigkeitswert ($m(u_{k,l})$) so ermittelt wird, daß die für mehrere Rahmen (k) gebildete Summe der Abweichungen eines fehlerfreien Hilfszuverlässigkeitswertes für den jeweiligen Rahmen (k) und des für denselben Rahmen (k) ermittelten Hilfszuverlässigkeitswertes ($m(u_{k,l})$) minimal wird,
   und daß unter Verwendung der Umrechnungsfunktion oder der Approximationsfunktion aus dem ermittelten Hilfszuverlässigkeitswert ($m(u_{k,l})$) der aktuelle Zuverlässigkeitswert ($L(u_{k,l})$) bestimmt wird.

2. Verfahren nach Anspruch 1, **dadurch gekennzeichnet, daß** für den Hilfszuverlässigkeitswert die folgende Formel gilt:

$$m(u_l)=P(u_l=+1)-P(u_l=-1),$$

wobei $u_l$ den Wert der Bitstelle 1 innerhalb des Rahmens bezeichnet, $P(u_l=+1)$ die Wahrscheinlichkeit dafür ist, daß der Wert $u_l$ einen ersten Wert hat, vorzugsweise den numerischen Wert "+1", und wobei $P(u_l=-1)$ die Wahrscheinlichkeit dafür ist, daß der Wert $u_l$ einen zweiten Wert hat, vorzugsweise "-1".

3. Verfahren nach Anspruch 1 oder 2, **dadurch gekennzeichnet, daß** der aktuelle Hilfszuverlässigkeitswert ($m(u_{k,l})$) rekursiv, vorzugsweise unter Verwendung eines Kalman-Filters (20), aus dem für den zuletzt bearbeiteten Rahmen (k-1) ermittelten Hilfszuverlässigkeitswert ($m(u_{k-1,l})$) berechnet wird.

4. Verfahren nach Anspruch 3, **dadurch gekennzeichnet, daß** der aktuelle Hilfszuverlässigkeitswert nach der folgenden Formel berechnet wird:

$$m_k = \rho_k\left(m_{k-1} + K_k\left(m^{\bullet}_{k-1} - m_{k-1}\right)\right)$$

und/oder daß der aktuelle Wahrscheinlichkeitswert $m_k$ nach folgender Formel berechnet wird:

$$m_k = \rho_k m k_{-1} + K_k(m^*{}_k - \rho_k m_{k-1})$$

wobei $m_k$ der Hilfszuverlässigkeitswert für den Rahmen k, $\rho_k$ ein Korrelationskoeffizient, $m^*{}_k$ bzw. $m^*{}_{k-1}$ der beobachtete Hilfszuverlässigkeitswert und Kk bzw. $K_{k-1}$ ein Verstärkungsfaktor ist, der vorzugsweise nach der folgenden Formel rekursiv bestimmt wird:

$$K_k = \frac{\sigma^2_{w,k-1} + \rho^2_k \sigma^2_{v,k-1} K_{k-1}}{\sigma^2_{w,k-1} + \sigma^2_{v,k} + \rho^2_k \sigma^2_{v,k-1} K_{k-1}}$$

wobei $\sigma^2_{w,k-1}$ die Varianz einer Systemstörung und $\sigma^2_{v,k-1}$ die Varianz einer Meßstörung sind.

5. Verfahren nach Anspruch 4, **dadurch gekennzeichnet, daß** der Korrelationskoeffizient $\rho_k$, die Varianz $\sigma^2_w$ der Systemstörung und die Varianz $\sigma^2_v$ der Meßstörung fest vorgegeben werden, wobei bei der Vorgabe vorzugsweise Messungen berücksichtigt werden.

6. Verfahren nach einem der vorhergehenden Ansprüche, **dadurch gekennzeichnet, daß** bei der Ermittlung des aktuellen Zuverlässigkeitswertes folgendes mathematisches Modell verwendet wird:

$$X_k = \Phi_{k,k-1}X_{k-1} + W_k$$

und

$$Z_k = H_k X_k + V_k$$

wobei $X_k$ einen Zustandsvektor für den Rahmen k, $\Phi_k$ eine Systemmatrix, $W_k$ einen Systemstörvektor, $Z_k$ einen Meßvektor, $H_k$ eine Meßmatrix und $V_k$ einen Meßstörvektor bezeichnen.

7. Verfahren nach einem der vorhergehenden Ansprüche, **dadurch gekennzeichnet, daß** es zum Decodieren von codiert übertragenen Daten verwendet wird.

8. Verfahren nach einem der vorhergehenden Ansprüche, **dadurch gekennzeichnet, daß** das Verfahren bei einer Datenübertragung in einem Mobilfunksystem eingesetzt wird, das vorzugsweise nach dem GSM-Standard arbeitet.

9. Verfahren nach Anspruch 8, **dadurch gekennzeichnet, daß** in der Bitstelle (1) vorzugsweise ein höherwertiges Bit eines im Rahmen (k) übertragenen Parameters übertragen wird.

**10.** Einrichtung (16) zum Bearbeiten von Empfangsdaten, insbesondere zum Durchführen des Verfahrens nach einem der vorhergehenden Ansprüche,

mit einer Empfangseinheit zum Empfangen von über eine Übertragungsstrecke (14) übertragenen Daten, die in Rahmen (k, k-1) aus einer vorgegebenen Anzahl von Bitstellen (1) übertragen werden,

einer Metrikinkrementeinheit (18), welche die empfangenen Daten mit Hilfe eines Metrikinkremente verwendenden Maximum-Aposteriori-Wahrscheinlichkeitsalgorithmus oder Maximum-Likelihood-Algorithmus bearbeitet,

mit einer Recheneinheit (20), die für mindestens eine Bitstelle (1), deren Wert und/oder Zuverlässigkeitswert von Rahmen (k) zu Rahmen (k-1) korreliert, einen aktuellen Zuverlässigkeitswert ($L(u_{k,l})$) ermittelt, der an die Metrikinkrementeinheit (18) ausgegeben wird,

wobei die Recheneinheit (20) zum Ermitteln des aktuellen Zuverlässigkeitswerts ($L(u_{k,l})$) mindestens einen beobachteten Zuverlässigkeitswert ($L^*(\hat{u}_{k-1,l}), L^*(\hat{u}_{k,l})$) verwendet, der aus einem bereits bearbeiteten Rahmen (k-1) oder aus dem aktuell bearbeiteten Rahmen (k) für die Bitstelle (1) bestimmt wurde,

**dadurch gekennzeichnet, daß** die Recheneinheit (20) den Zuverlässigkeitswert ($L(u_{k,l})$) so ermittelt, daß die für mehrere Rahmen (k) gebildete Summe der Abweichungen eines fehlerfreien Zuverlässigkeitswertes eines Rahmens und des für denselben Rahmen (k) ermittelten Zuverlässigkeitswertes ($L(u_{k,l})$) minimal wird,

oder dadurch, daß die Recheneinheit (20) den Zuverlässigkeitswert ($L(u_{k,l})$) so ermittelt, daß die für mehrere Rahmen (k) gebildete Summe der Abweichungen eines im wesentlichen fehlerfreien Hilfszuverlässigkeitswertes für den jeweiligen Rahmen (k) und eines für denselben Rahmen (k) ermittelten Hilfszuverlässigkeitswertes ($m(u_{k,l})$) minimal wird, wobei die Hilfszuverlässigkeitswerte ($m(u_{k,l})$) aus den Zuverlässigkeitswerten ($L(u_{k,l})$) mittels einer Umrechnungsfunktion oder einer Approximationsfunktion berechnet werden.

**Claims**

**1.** Method for processing data received by a receiver (16),

in which data transmitted in successive frames (k) over a transmission link (14) are received, one frame (k) containing a predefined number of bit locations (1),

in which the received data are processed by means of a maximum a posteriori probability algorithm using metric increments or a maximum likelihood algorithm,

the metric increments for at least one bit location (1) whose value and/or reliability value ($L(u_{k,1})$ are/is correlated from frame (k) to frame (k-1) being calculated as a function of a current reliability value ($L(u_{k,l})$) determined for the frame (k) currently being processed, which is a measure of the probability that the value of the bit location (1) can be determined without error,

and in which, in order to determine the current reliability value ($L(u_{k,l})$), use is made of at least one observed reliability value ($L * (\hat{U}_{k-1,l}), L * (\hat{U}_{k,l})$), which is determined for the bit location (1) from a frame (k-1) which has already been processed or from the frame (k) currently being processed,

**characterized in that** a precise conversion function or an approximation function is used to determine an observed auxiliary reliability value ($m * (\hat{U}_{k-1,l})$) from the observed reliability value ($L * (\hat{U}_{k-1,l})$),

**in that** a current auxiliary reliability value ($m(u_{k,l})$) is determined in such a way that the sum, formed for several frames (k), of the deviations of an error-free auxiliary reliability value for the respective frame (k) and of the auxiliary reliability value ($m(u_{k,l})$) determined for the same frame (k) is minimized,

and **in that** the conversion function or the approximation function is used to determine the current reliability value ($L(u_{k,l})$) from the determined auxiliary reliability value ($m(u_{k,l})$).

**2.** Method according to Claim 1, **characterized in that** the following formula applies to the auxiliary reliability value:

$$m(u_1) = P(u_1 = +1) - P(u_1 = -1),$$

$u_1$ denoting the value of the bit location 1 within the frame, $P(u_1 = +1)$ being the probability that the value $u_1$ has a first value, preferably the numerical value "+1", and $P(u_1 = -1)$ being the probability that the value $u_1$ has a second value, preferably "-1".

**3.** Method according to Claim 1 or 2, **characterized in that** the current auxiliary reliability value ($m(u_{k,l})$) is calculated recursively, preferably using a Kalman filter (20), from the auxiliary reliability value ($m(u_{k-1,l})$) determined for the frame (k-1) last processed.

**4.** Method according to Claim 3, **characterized in that** the current auxiliary reliability value is calculated in accordance with the following formula:

$$m_k = \rho_k\left(m_{k-1} + K_k\left(m^*_{k-1} - m_{k-1}\right)\right)$$

and/or **in that** the current probability value $m_k$ is calculated in accordance with the following formula:

$$m_k = \rho_k mk_{-1} + K_k(m^*_k - \rho_k m_{k-1})$$

$m_k$ being the auxiliary reliability value for the frame k, $\rho_k$ being a correlation coefficient, $m^*_k$ and, respectively, $m^*_{k-1}$ being the observed auxiliary reliability value and $K_k$ and $K_{k-1}$, respectively, being a gain factor which is preferably determined recursively in accordance with the following formula:

$$K_k = \frac{\sigma^2_{w,k-1} + \rho^2_k\sigma^2_{v,k-1}K_{k-1}}{\sigma^2_{w,k-1} + \sigma^2_{v,k} + \rho^2_k\sigma^2_{v,k-1}K_{k-1}}$$

$\sigma^2_{w,k-1}$ being the variance of a system disturbance and $\sigma^2_{v,k-1}$ being the variance of a measurement disturbance.

5. Method according to Claim 4, **characterized in that** the correlation coefficient $\rho_k$, the variance $\sigma^2_w$ of the system disturbance and the variance $\sigma^2_v$ of the measurement disturbance are permanently predefined, measurements preferably being taken into account in the predefinition.

6. Method according to one of the preceding claims, **characterized in that** the following mathematical model is used in determining the current reliability value:

$$X_k = \Phi_{k,k-1}X_{k-1}+W_k$$

and

$$Z_k = H_kX_k+V_k$$

$X_k$ denoting a state vector for the frame k, $\Phi_k$ denoting a system matrix, $W_k$ denoting a system disturbance vector, $Z_k$ denoting a measurement vector, $H_k$ denoting a measurement matrix and $V_k$ denoting a measurement disturbance vector.

7. Method according to one of the preceding claims, **characterized in that** it is used for decoding data transmitted in encoded form.

8. Method according to one of the preceding claims, **characterized in that** the method is used in a data transmission in a mobile radio system, which preferably operates in accordance with the GSM standard.

9. Method according to Claim 8, **characterized in that** the bit transmitted in the bit location (1) is preferably a more significant bit of a parameter transmitted in the frame (k).

10. Device (16) for processing received data, in particular for carrying out the method according to one of the preceding claims,
having a receiving unit for receiving data which are transmitted over a transmission link (14) and which are transmitted in frames (k, k-1) comprising a predefined number of bit locations (1),
having a metric increment unit (18), which processes the received data by means of a maximum a posteriori probability algorithm using metric increments or a maximum likelihood algorithm,
having a computing unit (20) which, for at least one bit location (1) whose value and/or reliability value are/is correlated from frame (k) to frame (k-1), determines a current reliability value ($L(u_{k,l})$), which is output to the metric increment unit (18),

in order to determine the current reliability value (L(uk,1)), the computing unit (20) making use of at least one observed reliability value (L * ($\hat{U}_{k-1,l}$), L * ($\hat{U}_{k,l}$)), which has been determined for the bit location (1) from a frame (k-1) which has already been processed or from the frame (k) currently being processed,

**characterized in that** the computing unit (20) determines the reliability value (L($u_{k,l}$)) in such a way that the sum formed for several frames (k) of the deviations of an error-free reliability value of a frame and of the reliability value (L($u_{k,l}$)) determined for the same frame (k) is minimized,

or **in that** the computing unit (20) determines the reliability value (L($u_{k,l}$)) in such a way that the sum formed for several frames (k) of the deviations of an essentially error-free auxiliary reliability value for the respective frame (k) and of an auxiliary reliability value (m($u_{k,1}$)) determined for the same frame (k) is minimized, the auxiliary reliability values (m($u_{k,l}$)) being calculated from the reliability values (L($u_{k,l}$)) by means of a conversion function or an approximation function.

**Revendications**

1. Procédé de traitement de données reçues par un récepteur (16), dans lequel

des données transmises dans des cadres successifs (k) sur une distance de transmission (14) sont reçues, un cadre (k) contenant un nombre prédéterminé de positions de bit (I),

les données reçues sont traitées à l'aide d'un algorithme de maximum de vraisemblance a posteriori ou d'un algorithme de maximum de vraisemblance («maximum likelihood») utilisant des incréments métriques,

les incréments métriques pour au moins une position de bit (I) dont la valeur et / ou la valeur de fiabilité (L($u_{k,l}$)) est en corrélation de cadre (k) à cadre (k-1) étant calculés en dépendance d'une valeur de fiabilité (L($u_{k,l}$)) actuelle déterminée pour le cadre (k) en cours de traitement, ladite valeur de fiabilité étant une mesure de la vraisemblance que la valeur de la position de bit (I) puisse être déterminée sans erreur et

dans lequel est utilisée, pour déterminer la valeur de fiabilité actuelle (L($u_{k,l}$)), au moins une valeur de fiabilité observée (L*($\hat{U}_{k-1,l}$), L*($\hat{u}_{k,l}$)) déterminée sur la base d'un cadre (k-1) déjà traité ou d'un cadre (k) en cours de traitement pour la position de bit (I),

**caractérisé en ce qu'**une valeur de fiabilité auxiliaire observée (m* ($\hat{u}_{k-1,l}$)) est déterminée sur la base de la fonction de fiabilité observée (L*($\hat{u}_{k-1,l}$)) moyennant l'utilisation d'une fonction de conversion exacte ou d'une fonction d'approximation,

**en ce qu'**une valeur de fiabilité auxiliaire actuelle (m($u_{k,l}$)) est déterminée de manière que, formée pour plusieurs cadres (k), la somme des écarts d'une valeur de fiabilité auxiliaire exempte d'erreur pour chaque cadre (k) et de la valeur de fiabilité auxiliaire (m($u_{k,l}$)) déterminée pour le même cadre (k) est minimale et

**en ce que** la valeur de fiabilité actuelle (L($u_{k,l}$)) est déterminée sur la base de la valeur de fiabilité auxiliaire (m($u_{k,l}$)) déterminée, moyennant l'utilisation de la fonction de conversion ou de la fonction d'approximation.

2. Procédé selon la revendication 1, **caractérisé en ce que** la formule valable pour la valeur de fiabilité auxiliaire est la suivante:

$$m(u_l) = P(u_l = +1) - P(u_l = -1),$$

$u_l$ désignant la valeur de la position de bit I à l'intérieur du cadre, P($u_l$ = +1) étant la vraisemblance que la valeur $u_l$ ait une première valeur, à savoir de préférence la valeur numérique «+1», et P($u_l$ = -1) étant la vraisemblance que la valeur $u_l$ ait une deuxième valeur, à savoir de préférence «-1».

3. Procédé selon la revendication 1 ou 2, **caractérisé en ce que** la valeur de fiabilité auxiliaire actuelle (m($u_{k,l}$)) est calculée récursivement, de préférence moyennant l'utilisation d'un filtre de Kalman (20), sur la base de la valeur de fiabilité auxiliaire (m($u_{k-1,l}$)) déterminée pour le cadre (k-1) traité en dernier lieu.

4. Procédé selon la revendication 3, **caractérisé en ce que** la valeur de fiabilité auxiliaire actuelle est calculée selon la formule suivante:

$$m_k = \rho_k (m_{k-1} + K_k (m^*_{k-1} - m_{k-1}))$$

et / ou **en ce que** la valeur de vraisemblance actuelle $m_k$ est calculée selon la formule

$$m_k = \rho_k \, mk_{-1} + K_k \, (m^*_k - \rho_k m_{k-1}),$$

$m_k$ étant la valeur de fiabilité auxiliaire pour le cadre k, $\rho_k$ étant un coefficient de corrélation, $m^*_k$ resp. $m^*_{k-1}$ étant la valeur de fiabilité auxiliaire observée et $K_k$ resp. $K_{k-1}$ étant un facteur d'amplification déterminé de préférence récursivement selon la formule suivante:

$$K_k = \frac{\sigma^2_{w,k-1} + \rho^2_k \sigma^2_{v,k-1} K_{k-1}}{\sigma^2_{w,k-1} + \sigma^2_{v,k} + \rho^2_k \sigma^2_{v,k-1} K_{k-1}}$$

$\sigma^2_{w,k-1}$ étant la variance d'une perturbation du système et

étant la variance d'une perturbation de mesure.

5. Procédé selon la revendication 4, **caractérisé en ce que** le coefficient de corrélation $\rho_k$, la variance $\sigma^2_w$ de la perturbation du système et la variance $\sigma^2_v$ de la perturbation de mesure sont prédéterminés,
ladite prédétermination tenant de préférence compte de mesures.

6. Procédé selon l'une des revendications précédentes, **caractérisé en ce qu'**est utilisé, pour la détermination de la valeur de fiabilité actuelle, le modèle mathématique suivant:

$$X_k = \phi_{k,k-1} X_{k-1} + W_k$$

et

$$Z_k = H_k X_k + V_k$$

$X_k$ étant un vecteur d'état pour le cadre k, $\phi_k$ étant une matrice systémique, $W_k$ étant un vecteur de perturbation du système, $Z_k$ étant un vecteur de mesure, $H_k$ étant une matrice de mesure et $V_k$ étant un vecteur de perturbation de mesure.

7. Procédé selon l'une des revendications précédentes, **caractérisé en ce qu'**il est $\sigma^2_{v,k-1}$ utilisé pour décoder des données transmises codées.

8. Procédé selon l'une des revendications précédentes, **caractérisé en ce que** le procédé est mis en oeuvre pour une transmission de données dans un système radio mobile qui opère de préférence selon le standard GSM.

9. Procédé selon la revendication 8, **caractérisé en ce que** de préférence un bit de poids plus fort d'un paramètre transmis dans le cadre (k) est transmis dans la position de bit (I).

10. Dispositif (16) de traitement de données de réception, plus particulièrement pour exécuter le procédé selon l'une des revendications précédentes, comprenant
une unité de réception pour la réception de données transmises sur une distance de transmission (14), lesquelles sont transmises dans des cadres (k, k-1) composés d'un nombre prédéterminé de positions de bit (I),
une unité d'incrément métrique (18), laquelle traite les données reçues à l'aide d'un algorithme de maximum de vraisemblance a posteriori ou d'un algorithme de maximum de vraisemblance («maximum likelihood») utilisant des incréments métriques,
une unité de calcul (20), laquelle détermine, pour au moins une position de bit (I) dont la valeur et / ou la valeur de fiabilité est en corrélation de cadre (k) à cadre (k-1), une valeur de fiabilité actuelle ($L(u_{k,l})$), laquelle est émise à l'unité d'incrément métrique (18),
l'unité de calcul (20) utilisant, pour déterminer la valeur de fiabilité actuelle ($L(u_{k,l})$), au moins une valeur de fiabilité observée ($L^*(\hat{u}_{k-1,l})$, $L^*(\hat{u}_{k,l})$), laquelle a été déterminée sur la base d'au moins un cadre (k-1) déjà traité ou sur la base du cadre (k) en cours de traitement pour la position de bit (I),
**caractérisé en ce que** l'unité de calcul (20) détermine la valeur de fiabilité ($L(u_{k,l})$) de manière que, formée pour plusieurs cadres (k), la somme des écarts d'une valeur de fiabilité exempte d'erreur d'un cadre et de la valeur de fiabilité ($L(u_{k,l})$) déterminée pour le même cadre (k) est minimale ou
**en ce que** l'unité de calcul (20) détermine la valeur de fiabilité actuelle ($L(u_{k,l})$) est déterminée de manière que, formée pour plusieurs cadres (k), la somme des écarts d'une valeur de fiabilité auxiliaire sensiblement exempte d'erreur pour chaque cadre (k) et d'une valeur de fiabilité auxiliaire ($m(u_{k,l})$) déterminée pour le même cadre (k) est minimale, les valeurs de fiabilité auxiliaires ($m(u_{k,l})$) étant calculées sur la base des valeurs de fiabilité ($L(u_{k,l})$) au moyen d'une fonction de conversion ou d'une fonction d'approximation.

## FIG 1

Codeworte

$-1+1+1\cdots$      $\cdots-1+1\cdots$      $\cdots-1-\ +1\cdots$      $\cdots+0{,}2;-3{,}7;\cdots$

Recheneinheit
(Kalman)

20

26

$L(U_{K,l})$

24

22

$q_l{}'$ → Quellen-kodierer → $U_l$ → Kanal-kodierer → $X_{l,n}$ → Kanal $\otimes \oplus$ → $Y_{l,n}$ / $Lc_{l,n}$ → Kanal-dekoder (Viterbi) → $\hat{U}_l$ / $L^*(\hat{U}_{K-1,l})$ → Quellen-dekoder → $\hat{q}_l{}'$

$a_K$
Fading

$N_0$

10      12      14      18

8            16

für Rahmen K

EP 1 133 063 B1

# FIG 2

$L(U_{K,I})$

verzögert: $L^*(\hat{U}_{K-1,I})$

$L(U_{K,I})$

verzögert: $L^*(\hat{U}_{K,I})$

| $\cdots$ | $U_{K-1,I-1}$ | $U_{K-1,I}$ | $U_{K-1,I-1}$ | $\cdots$ | $\cdots$ | $U_{K,I-1}$ | $U_{K,I}$ | $U_{K,I+1}$ | $\cdots$ |

Rahmen K-1

Rahmen K

$\longrightarrow t$

EP 1 133 063 B1

EP 1 133 063 B1

## FIG 3

## FIG 4

# FIG 5

EP 1 133 063 B1

EP 1 133 063 B1

## FIG 6